# EUROPEAN PATENT APPLICATION

(11) **EP 3 159 301 A1**
(43) Date of publication of application: **26.04.2017**
(21) Application number: 16195086.0
(22) Date of filing: 21.10.2016
(51) Int. Cl.: B81B 3/00, G01L 19/00

(54) **MEMS SENSOR DEVICE HAVING INTEGRATED MULTIPLE STIMULUS SENSING**

(30) Priority: 22.10.2015 US 201514919986
(71) Applicant: NXP USA, Inc., Austin TX 78735 (US)
(72) Inventor: Li, Fengyuan, 5656 AG Eindhoven (NL); McNeil, Andrew C, 5656 AG Eindhoven (NL); Arvind, Salian, 5656 AG Eindhoven (NL); Schlarmann, Mark Edward, 5656 AG Eindhoven (NL); Dawson, Chad, 5656 AG Eindhoven (NL)
(74) Representative: Freescale law department - EMEA patent ops

(57) **Abstract**

A sensor device comprises a device structure (22) and a cap coupled with the device structure to produce a cavity in which components of the sensor device are located. The device structure includes a substrate (28,136,232) and a movable element (30,124,138,194,230) spaced apart from a surface (32,140) of the substrate. A port (34,142,234) extends through the substrate underlying the movable element. A sense element is spaced apart from the movable element and is displaced away from the port. The movable element and the sense element (40,42,146,148,150,152,190,244,246) form an inertial sensor to sense a motion stimulus as movement of the movable element relative to the sense element. An additional sense element (44,155,204,206,208,210,237) together with a diaphragm spans across the port. The movable element and the additional sense element form a pressure sensor for sensing a pressure stimulus from an external environment (84) as movement of the additional sense element together with the diaphragm relative to the movable element.

## Description

### TECHNICAL FIELD OF THE INVENTION

The present invention relates generally to microelectromechanical (MEMS) sensor devices. More specifically, the present invention relates to a MEMS sensor device having integrated multiple stimulus sensing capability.

### BACKGROUND OF THE INVENTION

Microelectromechanical systems (MEMS) devices are semiconductor devices with embedded mechanical components. MEMS devices include, for example, pressure sensors, accelerometers, gyroscopes, microphones, digital mirror displays, micro fluidic devices, and so forth. MEMS devices are used in a variety of products such as automobile airbag systems, control applications in automobiles, navigation, display systems, inkjet cartridges, and so forth.

As the uses for MEMS sensor devices continue to grow and diversify, increasing emphasis is being placed on the development of advanced silicon MEMS sensor devices capable of sensing different physical stimuli at enhanced sensitivities and for integrating these sensors into the same miniaturized package. These efforts are primarily driven by existing and potential high-volume applications in automotive, medical, commercial, and consumer products.

### BRIEF DESCRIPTION OF THE DRAWINGS

The accompanying figures in which like reference numerals refer to identical or functionally similar elements throughout the separate views, the figures are not necessarily drawn to scale, and which together with the detailed description below are incorporated in and form part of the specification, serve to further illustrate various embodiments and to explain various principles and advantages all in accordance with the present invention.
FIG. 1 shows a representative sectional side view of a microelectromechanical systems (MEMS) sensor device having integrated multiple stimulus sensing capability in accordance with an embodiment;
FIG. 2 shows a top view of a device structure of the MEMS sensor device of FIG. 1;
FIG. 3 shows a top view of a device structure that may be implemented within the MEMS sensor device of FIG. 1;
FIG. 4 shows a representative sectional side view of a MEMS sensor device having integrated multiple stimulus sensing capability in accordance with another embodiment;
FIG. 5 shows a top view of a device structure of the MEMS sensor device of FIG. 4;
FIG. 6 shows a top view of a device structure that may be implemented within the MEMS sensor device of FIG. 4;
FIG. 7 shows a representative sectional side view of a MEMS sensor device having integrated multiple stimulus sensing capability in accordance with another embodiment; and FIG. 8 shows a block diagram of a system that includes a MEMS sensor device.

### DETAILED DESCRIPTION

An embodiment entails a microelectromechanical systems (MEMS) sensor device with multiple stimulus sensing capability having a compact size, that is durable, and that can be cost effectively fabricated utilizing existing manufacturing techniques. In particular, the MEMS sensor device has at least two sensors, each of which senses a different physical stimulus. An integrated sensing capability is achieved in the MEMS sensor device through the use of at least one electrode that is shared between the two sensors. In an embodiment, the two sensors utilize a movable element, sometimes referred to as a proof mass, as the shared electrode. More particularly, the movable element and a sense element spaced apart from the movable element form an inertial sensor adapted to sense a motion stimulus as movement of the movable element relative to the sense element. Additionally, the movable element and an additional sense element form a pressure sensor. The pressure sensor uses a diaphragm spanning across a port in the MEMS sensor device, where the port exposes the diaphragm to an external environment. The diaphragm is movable in response to an external pressure stimulus, and the pressure sensor senses the pressure stimulus as movement of the additional sense element together with the diaphragm, relative to the movable element.

The instant disclosure is provided to explain in an enabling fashion the best modes, at the time of the application, of making and using various embodiments in accordance with the present invention. The disclosure is further offered to enhance an understanding and appreciation for the inventive principles and advantages thereof, rather than to limit in any manner the invention. The invention is defined solely by the appended claims including any amendments made during the pendency of this application and all equivalents of those claims as issued.

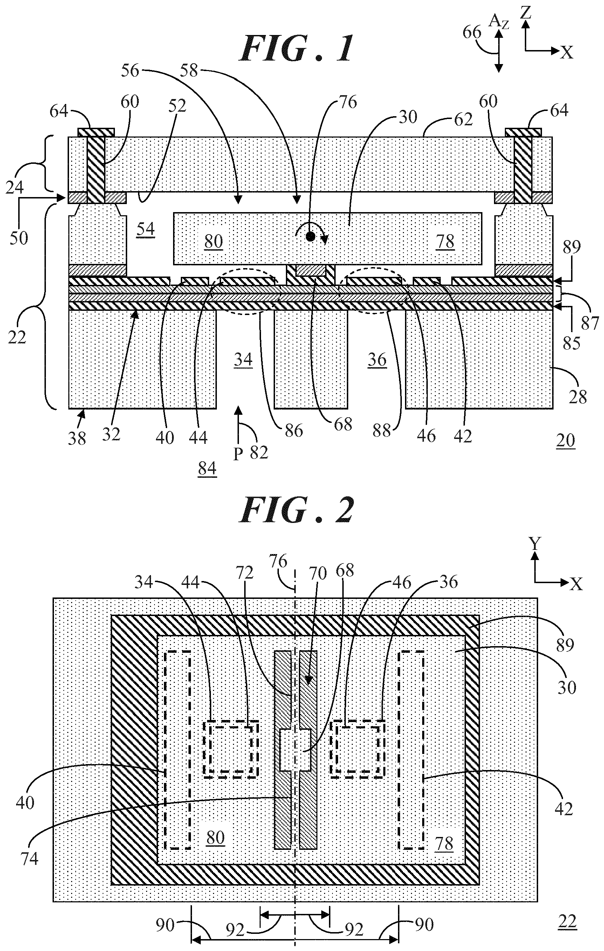

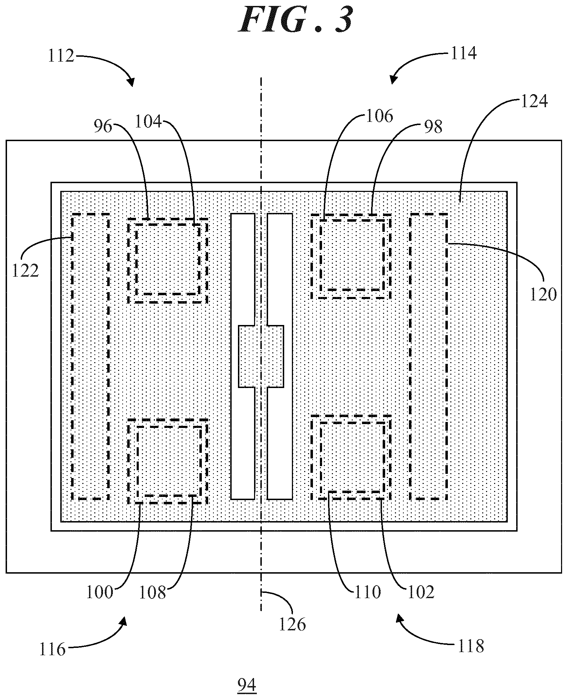

Referring to FIGs. 1 and 2, FIG. 1 shows a representative sectional side view of a MEMS sensor device 20 having integrated multiple stimulus sensing capability in accordance with an embodiment and FIG. 2 shows a top view of a device structure 22 of MEMS sensor device 20 (FIG. 1). FIGs. 1 and 2, and subsequent FIGs. 3-7 are illustrated using various shading and/or hatching to distinguish the different elements of the MEMS sensor device, as will be discussed below. These different elements within the structural layers may be produced utilizing current and upcoming micromachining techniques of depositing, patterning, etching, and so forth. Further, it should be understood that the use of relational terms, if any, such as first and second, top and bottom, and the like are used herein solely to distinguish one from another entity or action without necessarily requiring or implying any actual such relationship or order between such entities or actions.

MEMS sensor device 20 includes device structure 22 and a cap structure 24 coupled with device structure 22. Thus, FIG. 2 is shown with cap structure 24 removed to reveal the features of device structure 22. Additionally, FIG. 1 is a simplified cross-sectional view of MEMS sensor device 20 taken approximately along a horizontally oriented centerline of device structure 22 shown in FIG. 2. In an embodiment, device structure 22 includes a substrate 28 and a movable element, referred to herein as a proof mass 30, positioned in spaced apart relationship above a first surface 32 of substrate 28. Ports 34, 36 are formed in a second side 38 of substrate 28 underlying proof mass 30. Additionally, first sense elements 40, 42 are formed on first surface 32 of substrate 28 and second sense elements 44, 46 span across ports 34, 36.

Ports 34, 36 are visible in the side view illustration of FIG. 1. However, ports 34, 36 are obscured from view in FIG. 2 by proof mass 30. Thus, ports 34, 36 are represented by dashed line boxes in FIG. 2. Likewise, first sense elements 40, 42 and second sense elements 44, 46 are visible in the side view illustration of FIG. 1 and are obscured from view in FIG. 2 by proof mass 30. As such, sense elements 40, 42, 44, 46 are also represented by dashed line boxes in FIG. 2. The locations, quantities, shapes, and relative sizes of ports 34, 36, and sense elements 40, 42, 44, 46 are representative only. Those skilled in the art will appreciate that there may be other locations, quantities, shapes, and relative sizes of these elements in accordance with a particular design configuration.

In some embodiments, cap structure 24 is coupled to a top surface 48 of device structure 22 using an electrically conductive bonding layer 50 that forms a conductive interconnection between device structure 22 and cap structure 24. Conductive bonding layer 50 may be, for example, an Aluminum-Germanium (Al-Ge) bonding layer, a Gold-Tin (Au-Sn) bonding layer, a Copper-Copper (Cu-Cu) bonding layer, a Copper-Tin (Cu-Sn) bonding layer, an Aluminum-Silicon (Al-Si) bonding layer, and so forth. Bonding layer 50 may be suitably thick so that an inner surface 52 of cap structure 24 is displaced away from and does not contact proof mass 30 of device structure 22. Thus, a hermetically sealed cavity 54 is produced in which proof mass 30, first sense elements 40, 42, and second sense elements 44, 46 are located.

Cap structure 24 may be a silicon wafer material. Alternatively, cap structure 24 may be an application specific integrated circuit (ASIC) containing electronics associated with MEMS sensor device 20. In some configurations, cap structure 24 may additionally have cavity regions (not shown) extending inwardly from inner surface 52 of cap structure 24 to enlarge (i.e., deepen) cavity 54.

Cap structure 24 may include at least one electrically conductive through-silicon via (TSV) 60, also known as a vertical electrical connection (two shown), extending through cap structure 24 from inner surface 52 of cap structure 24 to an outer surface 62 of cap structure 24. Conductive via 60 may be electrically coupled with conductive bonding layer 50. Additionally, conductive via 60 may be electrically coupled to a conductive interconnect 64 formed on outer surface 62 of cap structure 24. Conductive interconnect 64 represents any number of wire bonding pads or electrically conductive traces leading to wire bonding pads formed on outer surface 62 of cap structure 24. Accordingly, conductive interconnects 64 can be located on outer surface 62 of cap structure 24 in lieu of being laterally displaced away from, i.e., beside, device structure 22 on a bond pad shelf.

In some embodiments, conductive interconnects 64 may be attached to a circuit board where MEMS sensor device 20 is packaged in a flip chip configuration. Such vertical integration effectively reduces the footprint of MEMS sensor device 20 relative to some prior art MEMS sensor devices. In other embodiments, second side 38 of substrate 28 may be coupled to a circuit board that has openings extending through it. Ports 34, 36 can therefore be aligned with the openings in the circuit board. As such, conductive interconnects 64 may be electrically connected to another device, such as a microcontroller (not shown), via bond wires. Only two conductive vias 60 are shown for simplicity of illustration. However, it should be understood that MEMS sensor device 20 may include more than two conductive vias 60 in accordance with a particular design configuration.

Proof mass 30 and first sense elements 40, 42 form an inertial sensor 56, such as an accelerometer, gyroscope, and the like adapted to sense a motion stimulus as movement of proof mass 30 relative to first sense elements 40, 42. Additionally, proof mass 30 and second sense elements 44, 46 form a pressure sensor 58 adapted to sense a pressure stimulus from an external environment as movement of second sense elements 44, 46 relative to proof mass 30. Thus, both inertial sensor 56 and pressure sensor 58 of MEMS sensor device 20 are co-located in a single cavity 54. Such an integrated sensor configuration can result in a smaller die size relative to sensor systems that have separate transducers, e.g., an accelerometer and a pressure sensor.

With continued reference to both of FIGs. 1 and 2, in the example embodiment, inertial sensor 56 is in the form of an accelerometer adapted to sense Z-axis acceleration (Az), represented by an arrow 66 in FIG. 1, and is constructed as a "teeter-totter" type sensor. As such, a suspension anchor 68 is formed on substrate 28 and is positioned at an approximate center of an opening 70 extending through proof mass 30. Torsion springs 72, 74 interconnect proof mass 30 with suspension anchor 68 so that proof mass 30 is suspended above and spaced apart from first sense elements 40, 42 and second sense elements 44, 46. Torsion springs 72, 74 enable pivoting or rotational motion of proof mass 30 about an axis of rotation 76.

Since inertial sensor 56 is intended for operation as a teeter-totter type accelerometer, a first section 78 of proof mass 30 on one side of axis of rotation 76 is formed with relatively greater mass than a second section 80 of proof mass 30 on the other side of axis of rotation 76. In an example embodiment, the greater mass of first section 78 may be created by offsetting axis of rotation 76 such that first section 78 is longer than second section 80. Although, the difference in mass between first section 78 and second section 80 is formed by offsetting axis of rotation 76, in alternative embodiments, this difference in mass may be accomplished by adding mass to first section 78 through an additional layer of material, by removing mass from second section 80 relative to first section 78, and so forth. Proof mass 30 is adapted for rotation about axis of rotation 76 in response to acceleration 66, thus changing its position relative to the underlying sense electrodes, i.e., first sense elements 40, 42. This change in position results in a set of capacitances whose difference, i.e., a differential capacitance, is indicative of the magnitude of acceleration 66. Accordingly, inertial sensor 56 is adapted to sense a motion stimulus, e.g., Z-axis acceleration 66, as movement of proof mass 30 relative to first sense elements 40, 42.

Now regarding pressure sensor 58 of MEMS sensor device 20, pressure sensor 58 is configured to sense a pressure stimulus (P), represented by an arrow 82, from an environment 84 external to MEMS sensor device 20. As such, ports 34, 36 extend from second surface 38 through substrate 28 to expose second sense elements 44, 46 to external environment.

In an embodiment, second sense element 44 includes a diaphragm 86 interposed between proof mass 30 and port 34. Likewise, second sense element 46 includes a diaphragm 88 interposed between proof mass 30 and port 36. Diaphragms 86, 88 may include multiple electrically conductive and dielectric material layers. Thus, diaphragms 86, 88 are demarcated by dashed line ovals to illustrate that the entire thickness and various material layers spanning ports 34, 36 function collectively as diaphragms 86, 88.

In an example, an electrically conductive polysilicon layer 85 may be formed on first surface 32 of substrate 28. One or more dielectric material layers, collectively referred to as an isolation layer 87 may then be formed on polysilicon layer 85. Isolation layer 87 can include, for example, an oxide layer (represented by upwardly and rightwardly directed narrow hatching) formed on polysilicon layer 85 followed by a nitride layer (represented by downwardly and rightwardly directed narrow hatching) formed on the oxide layer. Another polysilicon layer 89 may be deposited on the oxide layer and thereafter patterned and etched to form first sense elements 40, 42 and second sense elements 44, 46. Polysilicon layer 89 may additionally be patterned and etched to form conductive traces and the like (not shown) for suitably carrying signals from sense elements 40, 42, 44, 46. Accordingly, the multiple material layers 85, 87, 89 spanning ports 34, 36 yield diaphragms 86, 88, with the topmost polysilicon layer 89 functioning as second sense elements 44, 46.

The multiple conductive and dielectric material layers 85, 87, 89 are suitably thin so that diaphragms 86, 88 are movable in response to pressure stimulus (P) 82 from external environment 84. That is, diaphragms 86, 88 together with second sense elements 44, 46 are exposed to external environment 84 via ports 34, 36. Consequently, second sense elements 44, 46 together with diaphragms 86, 88 are capable of movement in a direction that is generally perpendicular to a plane of device structure 22 in response to pressure stimulus 82 from external environment 84. Although one example is shown, other embodiments may have fewer than or more than the particular material layers 85, 87, 89 described above. Furthermore, it should be emphasized that material layers 85, 87, 89 making up diaphragms 86, 88 with second sense electrodes 44, 46 are not drawn to scale. In a physical configuration, diaphragms 86, 88 may be significantly thinner than, for example, proof mass 30 so that they are able to effectively deflect relative to proof mass 30 in response to pressure stimulus 82.

Pressure sensor 58 uses proof mass 30 as a reference element for second sense elements 44, 46 and the pressure within cavity 54 to create a variable capacitor to detect deflection of diaphragms 86, 88 containing second sense elements 44, 46 due to applied pressure, i.e., pressure stimulus 82. As such, pressure sensor 58 senses pressure stimulus 82 from environment 84 as movement of second sense elements 44, 46 relative to proof mass 30. This change in position results in a set of capacitances whose summation is indicative of the magnitude of pressure stimulus 82. Accordingly, pressure sensor 58 is adapted to sense pressure stimulus 82 as movement of second sense elements 44, 46 together with diaphragms 86, 88 relative to proof mass 30.

As mentioned above, first sense elements 40, 42 are formed on first surface 32 of substrate 28 underlying proof mass 30. In such a configuration, first sense elements 40, 42 are laterally spaced away from and are electrically isolated from second sense elements 44, 46. More particularly, first sense elements 40, 42 are disposed on opposing sides of axis of rotation 76 and each is displaced a first distance 90 away from axis of rotation 76. Second sense elements 44, 46 are also disposed on opposing sides of axis of rotation 76. Each of second sense elements 44, 46 is displaced a second distance 92 away from axis of rotation 76, where second distance 92 is less than first distance 90.

Accordingly, second sense elements 44, 46 are located closer to axis of rotation 76 than first sense elements 40, 42 are. The closer placement of second sense elements 44, 46 (and commensurately, ports 34, 36) to axis of rotation 76, results in a smaller gap change between second sense elements 44, 46 and proof mass 30 as proof mass 30 is subjected to acceleration 66. The relatively small change in gap size between second sense elements 44, 46 and proof mass 30 effectively decreases the potential for acceleration 66 being detected at second sense elements 44, 46. Conversely, the more distant placement of first sense elements 40, 42 from axis of rotation 76, results in a larger gap change between first sense elements 40, 42 and proof mass 30 as proof mass 30 is subjected to acceleration 66, thereby effectively enabling the detection of acceleration 66 at first sense elements 40, 42. In the integrated configuration of MEMS sensor device 20, some crosstalk may occur in which, for example, Z-axis acceleration 66 is detected at second sense elements 44, 46 from the variable gap size. This non-ideality may be at least partially compensated for by first measuring acceleration at second sense elements 44, 46 and then calculating a correction factor for pressure sensor 58.

FIG. 3 shows a top view of a device structure 94 that may be implemented within MEMS sensor device 20 (FIG. 1). Device structure 94 provides an example configuration that includes four ports 96, 98, 100, 102 and four sense elements 104, 106, 108, 110 (which may be constructed as discussed above in connection with FIGs. 1 and 2) spanning their respective ports 96, 98, 100, 102 that make up a total of four pressure sensor elements 112, 114, 116, 118. Such a configuration additionally includes sense elements 120, 122 used to form an inertial sensor, as described previous. In this illustration, a proof mass 124 overlies ports 96, 98, 100, 102, sense elements 104, 106, 108, 110, and sense elements 120, 122. Thus, these features are thus presented in dashed line form to demonstrate their positions relative to an axis of rotation 126 of proof mass 124.

Each of pressure sensor elements 112, 114, 116, 118 is adapted to sense pressure stimulus 82 (FIG. 1) as movement of their respective sense elements 104, 106, 108, 110 relative to proof mass 124 and provide a pressure signal, e.g., a capacitance output, indicative of a magnitude of pressure stimulus 82. The four independent pressure signals from the four pressure sensor elements 112, 114, 116, 118 can be combined by summation to provide a pressure output signal from the MEMS sensor device. Thus, the multiple pressure sensor elements 112, 114, 116, 118 can effectively increase the sensitivity of the pressure sensor, relative to the two port design shown in FIGs. 1-2, within an integrated MEMS sensor device. It should be understood that an integrated MEMS sensor device, such as MEMS sensor device 20 (FIG. 1), can have any number of ports, sense elements, and diaphragms to achieve a sensitivity within a particular design specification and limited by the size of the movable element, e.g., proof mass, serving as the reference electrode.

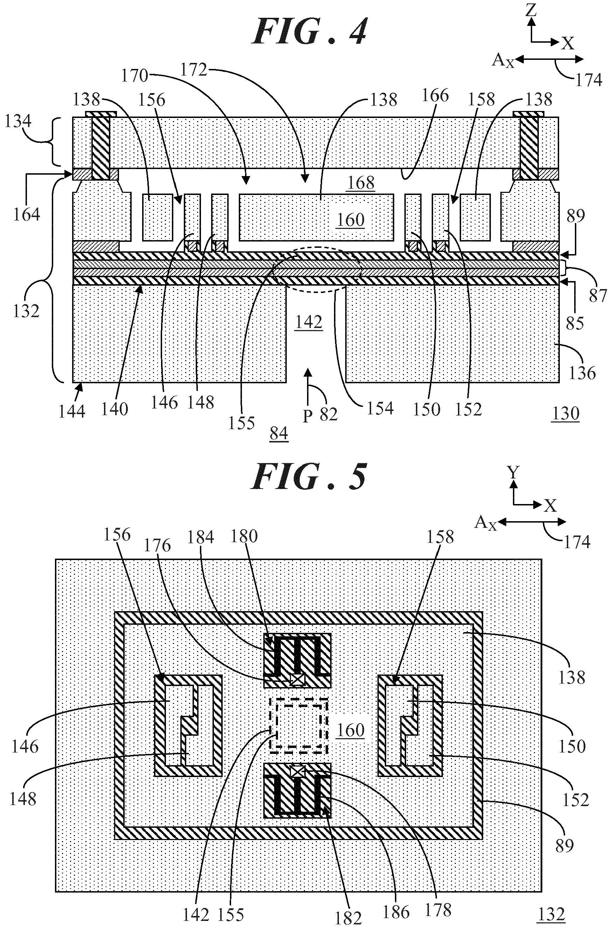

Now referring to FIGs. 4-5, FIG. 4 shows a representative sectional side view of a MEMS sensor device 130 having integrated multiple stimulus sensing capability in accordance with another embodiment and FIG. 5 shows a top view of a device structure 132 of MEMS sensor device 130. MEMS sensor device 20 (FIGs. 1-2) demonstrated an integrated sensor device having a teeter-totter style movable element for sensing acceleration along a Z-axis. In accordance with the embodiment of FIGs. 4-5, MEMS sensor device 130 has a movable element adapted to move laterally in response to an X- and/or Y-axis stimulus.

To that end, MEMS sensor device 130 includes device structure 132 and a cap structure 134 coupled with device structure 132. In an embodiment, device structure 132 includes a substrate 136 and a movable element, referred to herein as a proof mass 138, positioned in spaced apart relationship above a first surface 140 of substrate 136. A port 142 is formed in a second side 144 of substrate 136 underlying proof mass 138. Additionally, first sense elements 146, 148, 150, 152 are formed on first surface 140 of substrate 136. The multiple conductive and dielectric material layers 85, 87, 89 span port 142 to form a diaphragm 154, with the topmost polysilicon layer 89 functioning as an electrode, i.e., a second sense element 155.

Proof mass 138 is adapted to move laterally in response to an X- and/or Y-axis stimulus. That is, proof mass 138 is configured to move in a plane substantially parallel to first surface 140 of substrate 136. Thus, openings 156, 158 extend through proof mass 138, with first sense elements 146, 148 being formed in the same structural layer as proof mass 138 and residing in opening 156 and with first sense elements 150, 152 being formed in the same structural layer as proof mass 138 and residing in opening 158. Conversely, second sense element 155 is laterally displaced away from first sense elements 146, 148, 150, 152 and underlies a region 160 of proof mass 138 that is devoid of openings 156, 158.

As shown in the representative views of MEMS sensor device 130, first sense elements 146, 148, 150, 152 are visible in both of FIGs. 4 and 5 due to their locations within openings 156, 158. However, although port 142 and second sense element 155 are visible in the side view illustration of FIG. 4, they are obscured from view in FIG. 5 by proof mass 138. Thus, port 142 and second sense element 155 are represented by dashed line boxes in FIG. 5.

Cap structure 134 is coupled with device structure 132 using a bonding layer 164. Bonding layer 164 may be suitably thick so that an inner surface 166 of cap structure 134 is displaced away from and does not contact proof mass 138 and first sense elements 146, 148, 150, 152 of device structure 132. Thus, a hermetically sealed cavity 168 is produced in which proof mass 138, first sense elements 146, 148, 150, 152, and second sense element 155 are located. Cap structure 134 may be a silicon wafer material or, alternatively, an ASIC containing electronics associated with MEMS sensor device 130. Additionally, cap structure 134 may include through-silicon vias and other structures discussed above in connection with cap structure 24 (FIG. 1). Details of these structures are not repeated herein for brevity.

Like MEMS sensor device 20, MEMS sensor device 130 includes a single cavity 168 in which an inertial sensor 170 and a pressure sensor 172 are co-located. Proof mass 138 and first sense elements 146, 148, 150, 152 form inertial sensor 170, such as an accelerometer, gyroscope, and the like adapted to sense a motion stimulus as movement of proof mass 138 relative to first sense elements 146, 148, 150, 152. Additionally, proof mass 138 and second sense element 155 form pressure sensor 172 adapted to sense pressure stimulus 82 from external environment 84 as movement of second sense element 155 together with diaphragm 154 relative to proof mass 138. In the integrated configuration of MEMS sensor device 130, some crosstalk might occur in which, for example, a Z-axis acceleration could move proof mass 138 closer to the underlying second sense element 155 thereby effectively increasing the sensitivity of pressure sensor 172. Again, this non-ideality may be at least partially compensated for through optimization of spring elements 184, 186 and/or by calculating a correction factor for pressure sensor 172.

In the illustrated embodiment, inertial sensor 170 is in the form of an accelerometer adapted to sense X-axis acceleration (Ax), represented by an arrow 174 in FIGs. 4 and 5. As such, suspension anchors 176, 178 are formed on first surface 140 of substrate 136, in which suspension anchor 176 is positioned in an opening 180 and suspension anchor 178 is positioned in an opening 182 extending through proof mass 138. Suspension anchors 176, 178 are not visible in FIG. 4. However, suspension anchors 176, 178 are visible in FIG. 5, and are represented by boxes with an "X" marked through them to represent their attachment to the underlying structure.

Translatory spring elements 184, 186 interconnect proof mass 138 with suspension anchors 176, 178 so that proof mass 138 is suspended above and is spaced apart from the underlying polysilicon layer 89. Translatory spring elements 184, 186 enable translatory motion of proof mass 138 in the X-direction in response to X-axis acceleration 174. Translatory spring elements 184, 186 are shown in representative form and are compliant in the X-direction for simplicity of illustration. However, translatory spring elements 184, 186 may alternatively be compliant in the Y-direction or in both the X- and Y-directions. Furthermore, the shapes, relative sizes, locations, and quantities of translatory spring elements 184, 186, first port 142, sense elements 146, 148, 150, 152, 155 are representative only. Those skilled in the art will appreciate that there may be other shapes, relative sizes, locations, and quantities of these elements in accordance with a particular design configuration. Regardless, the integrated sensor configuration in which inertial sensor 170 and pressure sensor 172 share the same electrode (i.e., proof mass 138) can result in a smaller die size relative to sensor systems that have separate transducers, e.g., an lateral accelerometer and a pressure sensor.

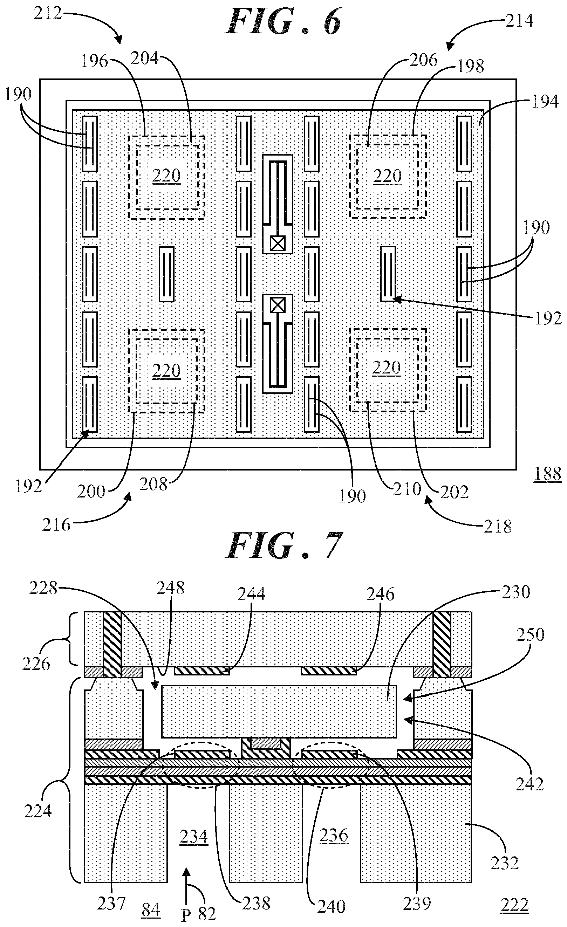

FIG. 6 shows a top view of a device structure 188 that may be implemented within MEMS sensor device 130 (FIG. 4). Device structure 188 provides an example configuration that includes a multiplicity of first sense elements, collectively referred to by the reference numeral 190 residing in openings 192 extending through a proof mass 194. Additionally, device structure 188 provides an example configuration that includes four ports 196, 198, 200, 202 and four sense elements 204, 206, 208, 210 (which may be constructed as discussed above in connection with FIGs. 1 and 2) spanning their respective ports 196, 198, 200, 202 that make up a total of four pressure sensor elements 212, 214, 216, 218. Ports 196, 198, 200, 202 and second sense elements 204, 206, 208, 210 underlie regions 220 of proof mass 194 that are devoid of openings 192. Thus, these features are presented in dashed line since they are hidden from view.

Like the configuration of FIG. 3, each of pressure sensor elements 212, 214, 216, 218 is adapted to sense pressure stimulus 82 (FIG. 1) as movement of their respective sense elements 204, 206, 208, 210 relative to proof mass 194 and provide a pressure signal, e.g., a capacitance output, indicative of a magnitude of pressure stimulus 82. The four independent pressure signals from the four pressure sensor elements 212, 214, 216, 218 can be combined by summation to provide a pressure output signal from the MEMS sensor device. Thus, the multiple pressure sensor elements 212, 214, 216, 218 can effectively increase the sensitivity of the pressure sensor, relative to the single port design shown in FIGs. 4-5, within the integrated MEMS sensor device. Furthermore, the multiplicity of first sense elements 190 yields a desired sensitivity of the inertial sensor capability of device structure 188.

FIG. 7 shows a representative sectional side view of a MEMS sensor device 222 having integrated multiple stimulus sensing capability in accordance with another embodiment. MEMS sensor device 222 includes a device structure 224 and a cap structure 226 coupled with device structure 224 to form a hermetically sealed cavity 228 in which a proof mass 230 is located. In an embodiment, proof mass 230 is positioned in spaced apart relationship above a substrate 232.

Ports 234, 236 are formed in substrate 232 underlying proof mass 230 and second sense elements 237, 239 with their corresponding diaphragms 238, 240 span across ports 234,236. Proof mass 230 and second sense elements 237, 239 form a pressure sensor 242 adapted to sense pressure stimulus 82 from external environment 84 as movement of second sense elements 237, 239 together with diaphragms 238, 240 relative to proof mass 230. However, in contrast to the previous embodiments, MEMS sensor device 222 further includes first sense elements 244, 246 formed on an inner surface 248 of cap structure 226. Proof mass 230 and first sense elements 244, 246 form an inertial sensor 250 adapted to sense a motion stimulus as movement of proof mass 230 relative to first sense elements 244, 246. This integrated sensor configuration can result in an even more compact die size relative to the MEMS sensor devices of FIGs. 1-6 since first sense elements 244, 246 are vertically displaced away from the second sense elements 237, 239 instead of being formed in the same material layer and laterally displaced away from the second sense elements as discussed in connection with the embodiments of FIGs. 1-6.

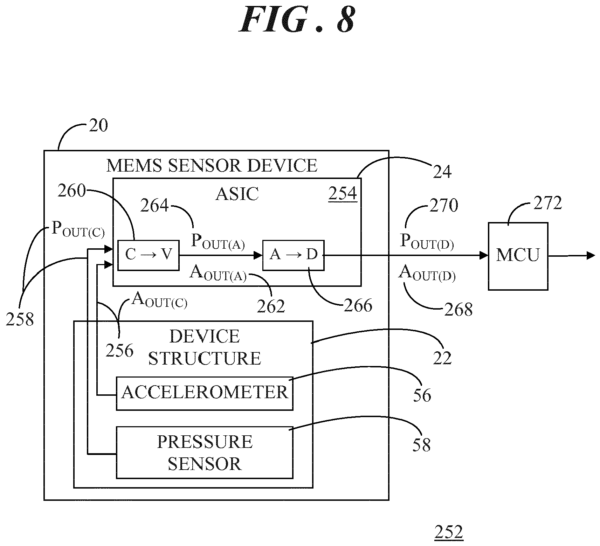

FIG. 8 shows a block diagram of a system 252 that includes a MEMS sensor device. In this example, system 252 includes MEMS sensor device 20 discussed in detail in connection with FIGs. 1-2. Thus, FIGs. 1-2 should be referred to concurrently with FIG. 8 and with the ensuing discussion of FIG. 8. Again, MEMS sensor device 20 includes device structure 22 having an inertial sensor 56 (e.g., an accelerometer) and pressure sensor 58. This example further illustrates a configuration in which cap structure 24 may be an application specific integrated circuit (ASIC) 254 in electrical communication with device structure by way of, for example, through-silicon vias 60 (FIG. 1).

ASIC 254 is configured to receive a first analog output signal 256, labeled A_{OUT(C)}, from inertial sensor 56, where first analog output signal 256 is produced from movement of proof mass 30 (FIG. 1) relative to first sense elements 40, 42 (FIG. 1). ASIC 254 is further configured to receive a second analog output signal 258, labeled P_{OUT(C)}, from movement of second sense elements 44, 46 (FIG. 1) together with diaphragms 86, 88 (FIG. 1) relative to proof mass 30. In some embodiments, first and second analog output signals 256, 258 may be variable capacitances and ASIC 254 may include capacitance-to-voltage converter circuitry 260 for converting first capacitive output signal 256 to a first analog voltage signal 262, labeled A_{OUT(A)} and for converting second capacitive output signal 258 to a second analog voltage signal 264, labeled P_{OUT(A)}.

ASIC 254 may further include analog-to-digital converter circuitry 266 for converting first and second analog voltage signals 262, 264 to first and second digital output signals 268, 270. That is, ASIC 254 is further configured to produce first digital output signal 268, labeled A_{OUT(D)}, from first analog voltage signal 262 and to produce second digital output signal 270, labeled P_{OUT(D)} from second analog voltage signal 264. First and second digital output signals 268, 270 may be output from MEMS sensor device 20 and communicated to a microcontroller 272 for further processing and/or transmission to another component (not shown) that forms part of system 252.

The analog front-end configuration of ASIC 254 having capacitance-to-voltage converter circuitry 260 and analog-to-digital converter circuitry 266 yields outputs, i.e., first and second digital output signals 268, 270, that are purely digital signals which typically have less reliability issues during transmission than analog signals. Furthermore, the integrated sensing capability of MEMS sensor device 20 with the attached ASIC 254 having front-end processing capability reduces the signal interconnections (e.g., wire bonds) thereby further reducing device reliability issues.

In summary, embodiments of a MEMS sensor device having multiple stimulus sensing capability and a method of producing such a MEMS sensor device have been described. An embodiment of a MEMS sensor device comprises a device structure. The device structure comprises a substrate having a port extending through the substrate, a movable element positioned in spaced apart relationship above a surface of the substrate, the port underlying the movable element, a first sense element spaced apart from the movable element, and a second sense element spanning across the port, wherein the port exposes the second sense element to a stimulus from an external environment.

According to an example, the first sense element is formed on the surface of the substrate underlying the movable element.

According to an example, the first sense element is laterally spaced apart from the second sense element.

According to an example, the first sense element is electrically isolated from the second sense element.

According to an example, the movable element and the first sense element form an inertial sensor. The inertial sensor is adapted to sense a motion stimulus as movement of the movable element relative to the first sense element. The movable element and the second sense element form a pressure sensor. The stimulus is a pressure stimulus. The second sense element includes a diaphragm interposed between the movable element and the port. The second sense element together with the diaphragm are movable in response to the pressure stimulus from the external environment. The pressure sensor is adapted to sense the pressure stimulus as movement of the diaphragm relative to the movable element.

According to an example, the movable element comprises first and second regions of differing mass that are separated by an axis of rotation about which the movable element rotates. The first sense element is formed on the substrate at a first distance displaced from the axis of rotation. The second sense element is positioned a second distance displaced from the axis of rotation. The second distance is less than the first distance.

According to an example, the movable element is configured to move in a plane substantially parallel to the surface of the substrate. The movable element includes at least one opening extending through the movable element. The first sense element resides in the opening in the movable element. The second sense element is laterally displaced away from the first sense element and underlies a region of the movable element that is devoid of the opening.

According to an example, the port is a first port. The substrate has a second port extending through the substrate. The device structure further comprises a third sense element spanning across the second port. The second port exposes the third sense element to the stimulus from the external environment.

According to an example, the stimulus is a pressure stimulus. The movable element and the second sense element form a first pressure sensor element. The second sense element includes a first diaphragm interposed between the movable element and the first port. The first diaphragm is movable in response to the pressure stimulus from the external environment. The first pressure sensor is adapted to sense the pressure stimulus as movement of the second sense element together with the first diaphragm relative to the movable element and provide a first pressure signal. The movable element and the third sense element form a second pressure sensor element. The third sense element includes a second diaphragm interposed between the movable element and the second port, the second diaphragm is movable in response to the pressure stimulus, the second pressure sensor element is adapted to sense the pressure stimulus as movement of the third sense element together with the second diaphragm relative to the movable element and provide a second pressure signal. The first and second pressure signals is combined to provide a pressure output signal from the MEMS sensor device.

According to an example, the MEMS sensor device further comprises a cap structure coupled with the device structure, to produce a cavity between the substrate and the cap structure in which the movable element is located.

According to an example, the cap structure comprises an inner surface located in the cavity and facing the movable element. The first sense element is formed on the inner surface.

According to an example, the second sense element spans across the port isolates the cavity from the external environment.

According to an example, the cap structure comprises an integrated circuit in electrical communication with the device structure. The integrated circuit is configured to receive a first analog output signal produced from movement of the movable element relative to the first sense element and to receive a second analog output signal produced from movement of the second sense element relative to the movable element. The integrated circuit is further configured to produce a first digital output signal from the first analog output signal and to produce a second digital output signal from the second analog output signal.

According to an example, a microelectromechanical systems (MEMS) sensor device comprises a device structure, which comprises a substrate, a movable element, a first sense element and a second sense element. The substrate has a port extending through the substrate. The movable element is positioned in spaced apart relationship above a surface of the substrate. The port underlies the movable element. The first sense element is spaced apart from the movable element. The movable element and the first sense element form an inertial sensor. The inertial sensor is adapted to sense a motion stimulus as movement of the movable element relative to the first sense element. The second sense element spans across the port. The port exposes the second sense element to a pressure stimulus from an external environment. The movable element and the second sense element form a pressure sensor. The second sense element includes a diaphragm interposed between the movable element and the port. The second sense element together with the diaphragm is movable in response to a pressure stimulus from the external environment. The pressure sensor is adapted to sense the pressure stimulus as movement of the second sense element relative to the movable element. The cap structure is coupled with the device structure, to produce a cavity between the substrate and the cap structure in which the movable element is located.

According to an example, the movable element comprises first and second regions of differing mass that are separated by an axis of rotation about which the movable element rotates. The first sense element is formed on the substrate at a first distance displaced from the axis of rotation. The second sense element is positioned a second distance displaced from the axis of rotation. The second distance is less than the first distance.

According to an example, the movable element is configured to move in a plane substantially parallel to the surface of the substrate. The movable element includes at least one opening extending through the movable element. The first sense element resides in the opening in the movable element. The second sense element is laterally displaced away from the first sense element and underlies a region of the movable element that is devoid of the opening.

According to an example, the cap structure comprises an inner surface located in the cavity and facing the movable element, and the first sense element is formed on the inner surface.

According to an example, the second sense element spans across the port isolates the cavity from the external environment.

An embodiment of a method of producing a MEMS sensor device comprises forming a device structure having a substrate, a movable element, a first sense element, and a second sense element, the movable element being positioned in spaced apart relationship above a first surface of the substrate, the first sense element being spaced apart from the movable element, and the second sense element being formed on the first surface of the substrate underlying the movable element. The method further comprises forming a port in a second surface of the substrate, the port extending through the substrate to expose the second sense element to a stimulus from an external environment, and coupling a cap structure with the first surface of the substrate to produce a cavity between the substrate and the cap structure in which the movable element is located, wherein the second sense element spans across the port to isolate the cavity from the external environment.

Thus, embodiments described herein include MEMS sensor devices and methodology that yields a MEMS sensor device with multiple stimulus sensing capability. In particular, the MEMS sensor device has at least two sensors, each of which senses a different physical stimulus. An integrated sensing capability is achieved in the MEMS sensor device through the use of at least one electrode that is shared between the two sensors. The two sensors utilize a movable element (i.e., proof mass) as the shared electrode. That is, the movable element and a sense element spaced apart from the movable element form an inertial sensor adapted to sense a motion stimulus as movement of the movable element relative to the sense element. Additionally, the movable element and an additional sense element form a pressure sensor. The pressure sensor uses a diaphragm spanning across a port in the MEMS sensor device, where the port exposes the diaphragm to an external environment. The diaphragm is movable in response to an external pressure stimulus, and the pressure sensor senses the pressure stimulus as movement of the additional sense element together with the diaphragm, relative to the movable element. The MEMS sensor device can be produced using existing MEMS fabrication processes to achieve design objectives of compact size, durability, enhanced reliability, and cost effective manufacturing.

This disclosure is intended to explain how to fashion and use various embodiments in accordance with the invention rather than to limit the true, intended, and fair scope and spirit thereof. The foregoing description is not intended to be exhaustive or to limit the invention to the precise form disclosed. Modifications or variations are possible in light of the above teachings. The embodiment(s) was chosen and described to provide the best illustration of the principles of the invention and its practical application, and to enable one of ordinary skill in the art to utilize the invention in various embodiments and with various modifications as are suited to the particular use contemplated. All such modifications and variations are within the scope of the invention as determined by the appended claims, as may be amended during the pendency of this application for patent, and all equivalents thereof, when interpreted in accordance with the breadth to which they are fairly, legally, and equitably entitled.

## Claims

1. A microelectromechanical systems (MEMS) sensor device, comprising:
a device structure (22) comprising:
a substrate (28, 136, 232) having a port (34, 142, 234) extending through said substrate;
a movable element (30, 124, 138, 194, 230) positioned in spaced apart relationship above a surface (32, 140) of said substrate, said port underlying said movable element;
a first sense element (40, 42, 146, 148, 150, 152, 190, 244, 246) spaced apart from said movable element; and
a second sense element (44, 155, 204, 206, 208, 210, 237) spanning across said port, wherein said port exposes said second sense element to a stimulus from an external environment (84).

2. The MEMS sensor device of claim 1, wherein said first sense element is formed on said surface of said substrate underlying said movable element.

3. The MEMS sensor device of claim 2, wherein said first sense element is laterally spaced apart from said second sense element.

4. The MEMS sensor device of any one of the claims 1 to 3, wherein said first sense element is electrically isolated from said second sense element.

5. The MEMS sensor device of any one of the claims 1 to 4, wherein:
said movable element and said first sense element form an inertial sensor (56, 170, 250), said inertial sensor being adapted to sense a motion stimulus as movement of said movable element relative to said first sense element; and
said movable element and said second sense element form a pressure sensor (58, 112, 114, 116, 118, 172, 212, 214, 216, 218, 242), wherein said stimulus is a pressure stimulus (82), said second sense element includes a diaphragm (86, 88, 154, 238, 240) interposed between said movable element and said port, said second sense element together with said diaphragm are movable in response to said pressure stimulus from said external environment, and said pressure sensor is adapted to sense said pressure stimulus as movement of said diaphragm relative to said movable element.

6. The MEMS sensor device of any one of the claim 1 to 5, wherein:
said movable element comprises first and second regions of differing mass that are separated by an axis of rotation (76, 126) about which said movable element rotates;
said first sense element is formed on said substrate at a first distance (90) displaced from said axis of rotation; and
said second sense element is positioned a second distance (92) displaced from said axis of rotation, said second distance being less than said first distance.

7. The MEMS sensor device of any one of the claim 1 to 6, wherein:
said movable element is configured to move in a plane substantially parallel to said surface of said substrate;
said movable element includes at least one opening (70, 180, 182, 192) extending through said movable element;
said first sense element resides in said opening in said movable element; and
said second sense element is laterally displaced away from said first sense element and underlies a region of said movable element that is devoid of said opening.

8. The MEMS sensor device of any one of the claim 1 to 7, wherein:
said port is a first port;
said substrate has a second port (36, 236) extending through said substrate; and
said device structure further comprises a third sense element (46, 239) spanning across said second port, wherein said second port exposes said third sense element to said stimulus from said external environment.

9. The MEMS sensor device of claim 8, wherein:
said stimulus is a pressure stimulus (82);
said movable element and said second sense element form a first pressure sensor element, said second sense element includes a first diaphragm (86, 238) interposed between said movable element and said first port, said first diaphragm is movable in response to said pressure stimulus from said external environment, said first pressure sensor being adapted to sense said pressure stimulus as movement of said second sense element together with said first diaphragm relative to said movable element and
provide a first pressure signal; and
said movable element and said third sense element form a second pressure sensor element, said third sense element includes a second diaphragm (88, 240) interposed between said movable element and said second port, said second diaphragm is movable in response to said pressure stimulus, said second pressure sensor element being adapted to sense said pressure stimulus as movement of said third sense element together with said second diaphragm relative to said movable element and provide a second pressure signal, and said first and second pressure signals being combined to provide a pressure output signal from said MEMS sensor device.

10. The MEMS sensor device of any one of the claims 1 to 9, further comprising a cap structure coupled with said device structure, to produce a cavity (54, 168, 228) between said substrate and said cap structure (24, 134, 236) in which said movable element is located.

11. The MEMS sensor device of claim 10, wherein said cap structure comprises an inner surface (52, 166, 248) located in said cavity and facing said movable element, and said first sense element is formed on said inner surface.

12. The MEMS sensor device of claim 10 or 11, wherein said second sense element spanning across said port isolates said cavity from said external environment.

13. The MEMS sensor device of any one of the claim 10 to 12, wherein said cap structure comprises an integrated circuit (254) in electrical communication with said device structure, said integrated circuit being configured to receive a first analog output signal (256) produced from movement of said movable element relative to said first sense element and to receive a second analog output signal (258) produced from movement of said second sense element relative to said movable element, and said integrated circuit being further configured to produce a first digital output signal (268) from said first analog output signal and to produce a second digital output signal (270) from said second analog output signal.

14. A method of producing a microelectromechanical systems (MEMS) sensor device comprising:
forming a device structure (22) having a substrate (28, 136, 232), a movable element (30, 124, 138, 194, 230), a first sense element (40, 42, 146, 148, 150, 152, 190, 244, 246), and a second sense element (44, 155, 204, 206, 208, 210, 237), said movable element being positioned in spaced apart relationship above a first surface (32, 140) of said substrate, said first sense element being spaced apart from said movable element, and said second sense element being formed on said first surface of said substrate underlying said movable element;
forming a port (34, 142, 234) in a second surface (38) of said substrate, said port extending through said substrate to expose said second sense element to an external environment; and
coupling a cap structure (24, 124, 136) with said first surface of said substrate to produce a cavity (54, 168, 228) between said substrate and said cap structure in which said movable element is located, wherein said second sense element spans across said port to isolate said cavity from said external environment.

15. The method of claim 14 wherein:
said movable element and said first sense element form an inertial sensor (56, 170, 250), said inertial sensor being adapted to sense a motion stimulus as movement of said movable element relative to said first sense element; and
said movable element and said second sense element form a pressure sensor (58, 112, 114, 116, 118, 172, 212, 214, 216, 218, 242), wherein said second sense element includes a diaphragm (86, 88, 154, 238, 240) interposed between said movable element and said port, said second sense element together with said diaphragm are movable in response to a pressure stimulus from said external environment, said pressure sensor being adapted to sense said pressure stimulus as movement of said second sense element relative to said movable element.
